Europäisches Patentamt

European Patent Office

Office européen des brevets

(11) Publication number: **0 039 406**
**B1**

## (12) EUROPEAN PATENT SPECIFICATION

(45) Date of publication of patent specification: **04.09.85**

(21) Application number: **81102202.9**

(22) Date of filing: **24.03.81**

(51) Int. Cl.⁴: **H 01 L 21/316, C 23 C 8/12, H 01 J 37/32**

(54) **Process for plasma oxidizing substrates.**

(30) Priority: **07.05.80 US 147684**

(43) Date of publication of application:
**11.11.81 Bulletin 81/45**

(45) Publication of the grant of the patent:
**04.09.85 Bulletin 85/36**

(84) Designated Contracting States:
**DE FR GB IT**

(56) References cited:
**EP-A-0 016 909
DE-A-2 726 265
FR-A-1 582 129
US-A-3 394 066**

(73) Proprietor: **International Business Machines Corporation
Old Orchard Road
Armonk, N.Y. 10504 (US)**

(72) Inventor: **Ray, Asit Kumar
70 Barker Street
Mt. Kisco New York 10549 (US)**
Inventor: **Reisman, Arnold
2294 Van Cortland Circle
Yorktown Heights, N.Y. 10598 (US)**

(74) Representative: **Oechssler, Dietrich, Dr. rer. nat.
Schönaicher Strasse 220
D-7030 Böblingen (DE)**

Courier Press, Leamington Spa, England.

## Description

This invention concerns the oxidation of a conductive or semiconductive surface, particularly the oxidation of a substrate which is to be employed in the fabrication of integrated circuits, and apparatus therefor. The plasma oxidation of the present invention can be carried out at relatively low temperatures.

Oxidation of substrates, such as semiconductive substrates, has been performed thermally in either wet or dry oxygen ambient atmospheres and at temperatures of about 800°C—1100°C.

With ongoing microminiaturization, conventional processes of thermal oxidation become increasingly untenable because at the elevated temperatures that are involved when developing complex structures, the device impurity profiles become redistributed and this, in turn, impacts device designs significantly.

Efforts have been underway to find oxidizing techniques that can be practiced at lower temperatures, preferably below about 700°C, at which temperature impurity diffusion coefficients become very small.

The art of plasma formation of oxide on semiconductors has been referred to as plasma growth, as plasma oxidation, or under circumstances where the semiconductor substrate is part of the anode electrode, the process is called anodization. In an article in "Solid State Electronics", Volume 17, page 627, 1974, oxide formation at constant voltage bias with no control of temperature is recorded.

Plasma oxidation of conductive or semiconductive materials and especially of a semiconductor, such as silicon, is of great interest since it has the potential of providing low temperature processing coupled with high oxidation rates. Low oxidation temperature essentially eliminates impurity redistribution and defect formation effects that are associated with normal high temperature oxidation processes.

DE—A—2 726 265 describes a method for growing a genetic semiconductor oxide layer whereby an electron beam is directed towards the substrate surface to be oxidized. The pressure of the oxygen environment is held at values of less than 1.2 Pa (9 mTorr). The electron beam has a given density and energy to achieve the desired oxide growth on the surface facing the beam.

The reported results on plasma oxidation vary widely with respect to the kinetics of the oxidation (e.g. linear or linear-parabolic), the frequency of the applied field (e.g. RF or microwave), the mode of plasma generation, such as with or without electrodes in the system, the use of biased or unbiased substrates (i.e. plasma anodization or oxidation), and the properties of the resultant plasma grown oxide (high flat band voltage). However, in all of these cases, the area of uniformly oxidized silicon was found to be very small and usually less than or equal to two square centimeters. In addition, the temperature of the oxidation was determined by the extent of plasma heating only. Accordingly, the reported results have not, in fact, been very promising.

In European patent application, Serial No. 80 10 32 52, Publication No. 16909, plasma oxide formation on semiconductor substrates is disclosed wherein the temperature control of the substrate, the pressure control, and the plasma power control are independent of each other. In the preferred embodiments in said application, the pressure is less than about 0.4 Pa (3 mTorr). When a semiconductive substrate, such as silicon, is placed perpendicular to the direction of gas flow at varying distances from the plasma generating region in low pressure regions, such as at about 0.4 Pa (3 mTorr) and less, $SiO_2$ is formed on the surface of the wafer. Upon examining the Si—$SiO_2$ interface using conventional SEM, techniques, it was found that $SiO_2$ is a deposited film. The thickness of the film increases linearly with time. In addition, it was noted that the rate of deposition increases with increasing power, decreasing pressure and decreasing distance from the plasma generating region. It was also found that the rate of deposition is independent of the temperature of the substrate. Moreover, in this method, the deposited oxides exhibited etch rates and refractive indices quite comparable to thermal oxide. Fixed charge and interface state densities were reasonable but on the high side following high and low temperature pre- and post-metallization annealing processes respectively. Thus, this known method does not solve all problems.

The present invention further improves plasma oxidation. It concerns a process for uniformly plasma oxidizing one surface of a metallic-type electrically conductive or a semiconductive substrate by placing it perpendicular to the flow of the plasma and in a region having a pressure of at least 1.3 Pa (10 mTorr). The surface of the substrate which is not to be oxidized faces the plasma. This surface shows very little, if any, oxide formation in a reasonable time. The surface of the substrate not facing the plasma is oxidized at a rate comparable to that achievable in conventional dry oxygen thermal processes at 1100°C at temperatures, however, many hundreds of degrees lower.

The process of the present invention results in the formation on the reverse side (i.e. that surface not facing towards the plasma) of oxides with properties substantially equivalent to oxides which are grown thermally. However, the temperature to which the substrate must be subjected is much less than that used for thermally grown oxide. This is advantageous since oxidation at high temperatures tends to cause redistribution of or depletion of the dopants. Moreover, the ability to employ lower temperatures reduces and minimizes the danger of defect formation in the substrate due to its being subjected to the relatively high temperatures necessary for thermal oxide growth.

It is further noted that the process of the present invention makes it possible to uniformly oxidize relatively large areas (e.g. 25 cm²) whereby the thickness of the film formed is uniform with a deviation of only ±3—5%.

The present invention also concerns an apparatus for providing the plasma oxide growth. The apparatus includes a housing means capable of providing an evacuated environment and containing therein a plasma region having a controllable source of power. Also, the apparatus includes substrate mounting means located within the housing means, outside of the geometric confines of the source of power, and in a region capable of providing oxidation of a surface of the substrate which faces away from the plasma when the substrate is held by the substrate mounting means.

The following describes embodiments and ways of carrying out the invention, illustrated by drawings in which:

Fig. 1 is a schematic view of an apparatus for practice of the present invention.

Fig. 2 is a schematic view of another apparatus suitable for practice of the present invention, which apparatus is adapted for the simultaneous treatment of a plurality of substrates.

Fig. 3 is a graph of the variation of oxide thickness with pressure.

Fig. 4 is a graph of the variation of oxide thickness with time at varying temperatures.

Fig. 5 is a graph of the variation of oxide thickness with time for varying frequencies of applied power.

Fig. 6 is a graph of the variation of oxide thickness with time for varying power.

The plasma oxidation process of the present invention is applicable for treating oxidizable metallic-type electrically conductive substrates and oxidizable semiconductive substrates. The metallic-type electrically conductive substrate can be an electrically conductive metal, mixtures of electrically conductive metals, electrically conductive metallic alloys, as well as nonmetallic materials, such as highly doped polycrystalline silicon or intermetallic silicides which, nevertheless, have electrical conductivities of the magnitude generally possessed by metals.

The present invention is also applicable for the treatment of substrates containing or consisting or semiconductive materials, such as silicon, polycrystalline silicon, and the like. Moreover, the substrates treated can contain mixtures of metallic-type materials and semiconductors. The preferred substrates treated according to the present invention are silicon and polycrystalline silicon. These substrates can be doped or undoped. The doping can be from impurities which impart the same or different conductivity to that of the bulk of the substrate.

The process, according to the present invention, includes placing the substrate to be oxidized perpendicular to the flow of the plasma gas. The surface of the substrate to be oxidized is placed facing away from, rather than towards, the plasma. It is quite surprising that, according to the present invention, the surface of the substrate which does not face towards the plasma is oxidized to a much greater degree than the surface which faces towards the plasma.

In order that the surface of the substrate not facing towards the plasma be oxidized, the substrate must be present in a region having a pressure of at least about 10 mTorr. The preferred pressure is between 1.3 and about 13.3 Pa (10 and about 100 mTorr), and most preferably about 2.6 to about 6.7 Pa (about 20 to about 50 mTorr).

The temperature of the substrate during the oxidation is generally about 300°C to about 550°C, and preferably about 340°C to about 525°C.

In addition, according to the present invention, the reverse side of the substrate to be oxidized can be masked so that only desired portions thereof, less than the entire surface, are oxidized. Some suitable oxidation resistant mask materials include magnesium oxide and $Si_3N_4$.

The process of the present invention is preferably carried out by employing independent controls for the temperature of the substrate, for the pressure, and for the plasma power.

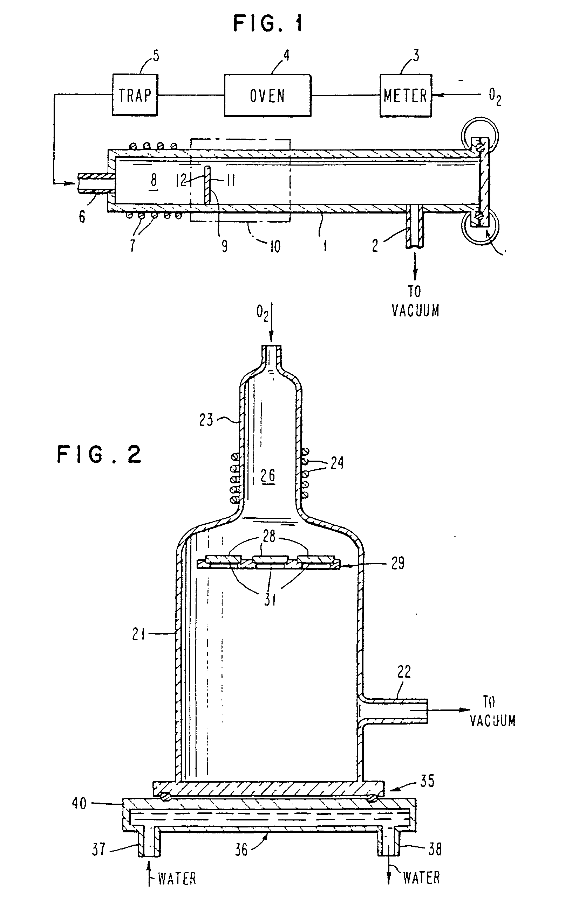

Fig. 1 is a schematic diagram of an apparatus suitable for carrying out the process of the present invention. In Fig. 1, a non-oxidizable container 1 (e.g. quartz) is shown which can be evacuated via conduit 2, and then a controlled amount of oxygen regulated by a mass flowmeter 3 is caused to flow through the system at a controlled pressure. The oxygen employed is preferably ultra-high purity (e.g. 99.99% $O_2$) which is further purified by being heated in an oven 4 to a temperature of about 900°C to about 1100°C, and preferably about 1000°C to decompose any hydrocarbons which might be present to $CO_2$ and $H_2O$. The $CO_2$ and $H_2O$ are removed from the $O_2$ by the liquid nitrogen trap 5. The oxygen is introduced into the container 1 via conduit 6. An oxygen plasma is generated by induction coil 7 connected by appropriate conductors (not shown) to a variable power radio frequency generator (not shown). This provides a plasma region 8 wherein the controlled ambient atmosphere is ionized using radio frequency excitation.

In a typical apparatus wherein the plasma region is about 76 mm in length and the apparatus is about 76 mm in diameter, the applied radio frequency power is about 1 to about 7 kW and preferably about 1 to about 2 kW. The frequency of the applied power is about 0.5 to about 8 MHz.

A substrate 9 is positioned vertically and perpendicular to the direction of gas flow on a holder (not shown). The holder should preferably be nonoxidizable, such as quartz, and can rest on the bottom surface of the container 1. The temperature of the substrate is independently controlled, such as by an external resistance heated furnace 10. The substrate 9 is outside the geometrical confines of the coil 7.

Typical substrates treated according to the present invention are boron doped p-type silicon wafers about 0.3 mm thick, about 57 mm (2.25 inches) in diameter, and of general circular configuration. Also, as shown, the substrates are not intentionally biased as electrodes in the system. When employing apparatus of the above-discussed general dimensions and operating at the above discussed conditions, the substrates are generally placed about 13 to about 51 mm from the plasma generation region in order to achieve the desired oxidation rates.

As indicated, the reverse side 11 of the substrate will be oxidized significantly, whereas the front side 12 facing the plasma region will be oxidized at a much reduced rate. Since the plasma is generated by an electrodeless system, electrode sputtering and contamination of the grown oxide by electrode sputtering do not occur. The apparatus also includes sealing means 13 which can be opened to insert the substrate to be oxidized.

The oxidation process usually takes between about 1/4 and about 8 hours for completion depending upon the oxide thickness desired.

Typical flow rates for oxygen through the above-defined system are about 0.7 to about 10 cm³ per minute.

In addition, if desired, the two substrates can be oxidized simultaneously in the type of configuration illustrated in Fig. 1 whereby one is placed on one side of the RF coil, and the other is placed on the opposite side of the RF coil.

Fig. 2 schematically illustrates another configuration which can be used to carry out the present invention, whereby a plurality of substrates can be treated simultaneously.

In Fig. 2, a non-oxidizable belljar container 21 (e.g. quartz) is shown which can be evacuated via conduit 22 when connected to a vacuum system (not shown). A controlled amount of purified oxygen is caused to flow into said container 21 via conduit or neck 23. For a typical arrangement, neck 23 is about 80 mm in diameter.

An oxygen plasma is generated by induction coil 24. The induction coil 24 is connected to a variable power radio frequency generator (not shown). This provides a plasma region 26 wherein the controlled oxygen ambient atmosphere is ionized using radio frequency excitation. The substrates 28 are located on a holder at position 29.

The holders can be in the form of a large disc or other shape having cut-out portions corresponding in shape and size to the substrates to be oxidized whereby the substrates can be fitted into the cut-out portions. In addition, the holder can include legs (not shown) attached to the disc or other shape for support on the base plate 40.

The substrates can be heated merely by the plasma gas or can be heated by resistance heaters (not shown). The surface 31 of the substrates will be oxidized.

The configuration of Fig. 2 also includes sealing means 35 which can be opened for removal or insertion of substrates. Means 35 can be cooled by water cooling means 36 whereby cool water can be introduced via conduit 37 and removed via conduit 38.

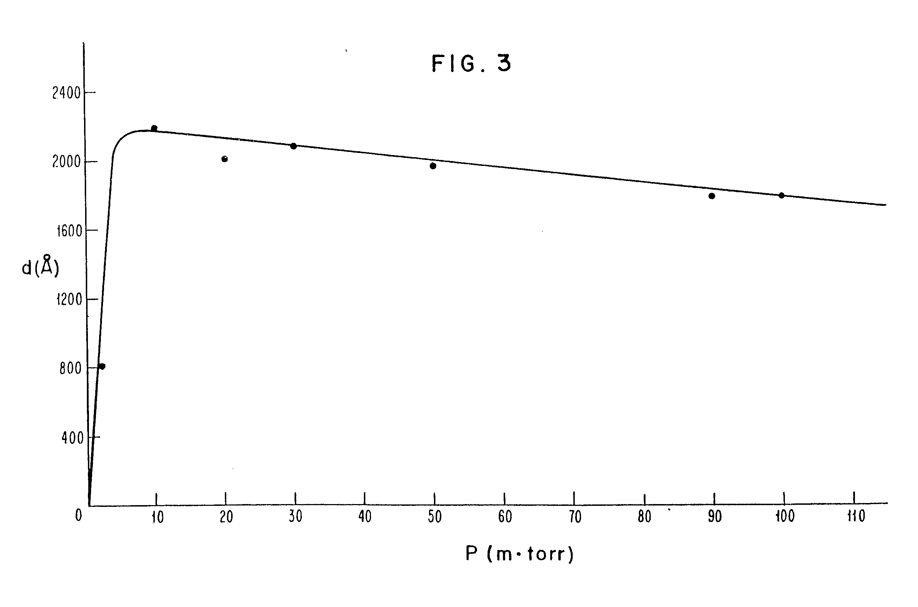

Fig. 3 illustrates the oxide thickness as a function of the pressure at 2 kW power for about 4 hours of oxidation time. It is noted that at about 1.3 Pa (10 mTorr), the oxide thickness significantly increases and remains substantially the same although decreasing somewhat as the pressure increases.

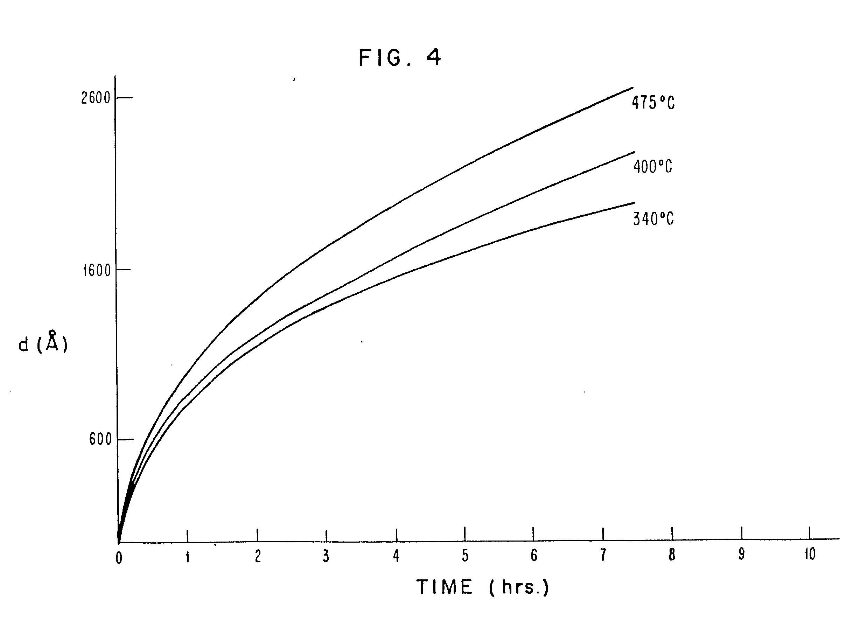

Fig. 4 illustrates the oxide thickness as a function of temperature over a period of time using 1 kW power, 2.15 cm³ $O_2$ per minute and at 4 Pa (30 mTorr). As noted from these curves, higher temperatures provide increased growth rate. The oxide growth behavior follows linear parabolic kinetics.

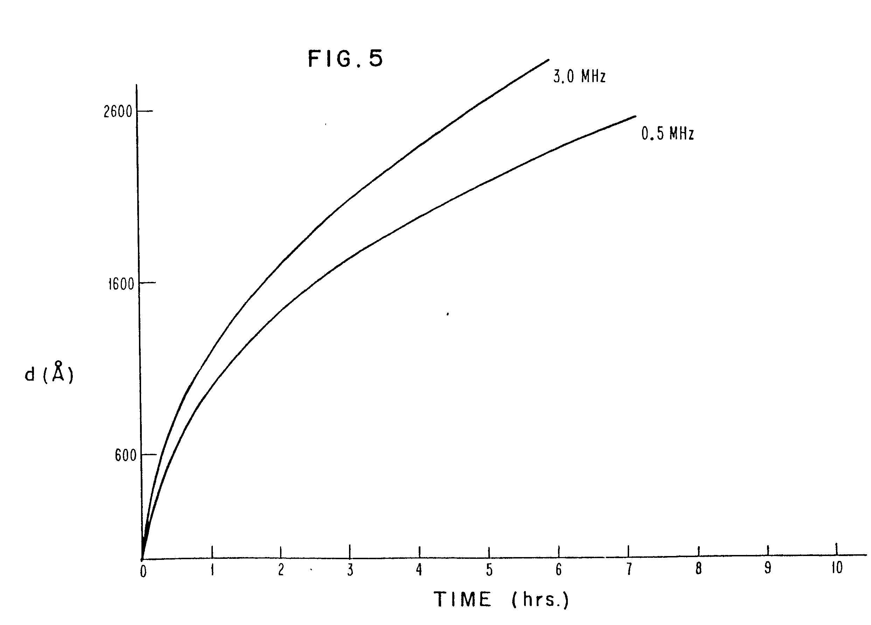

Fig. 5 illustrates oxide thickness as a function of frequency of power at 475°C, oxygen flow rate of 2.15 cm³ per minute and a pressure 30 mTorr and power of 1 kW. It is noted that the increased frequency increases oxide growth rate.

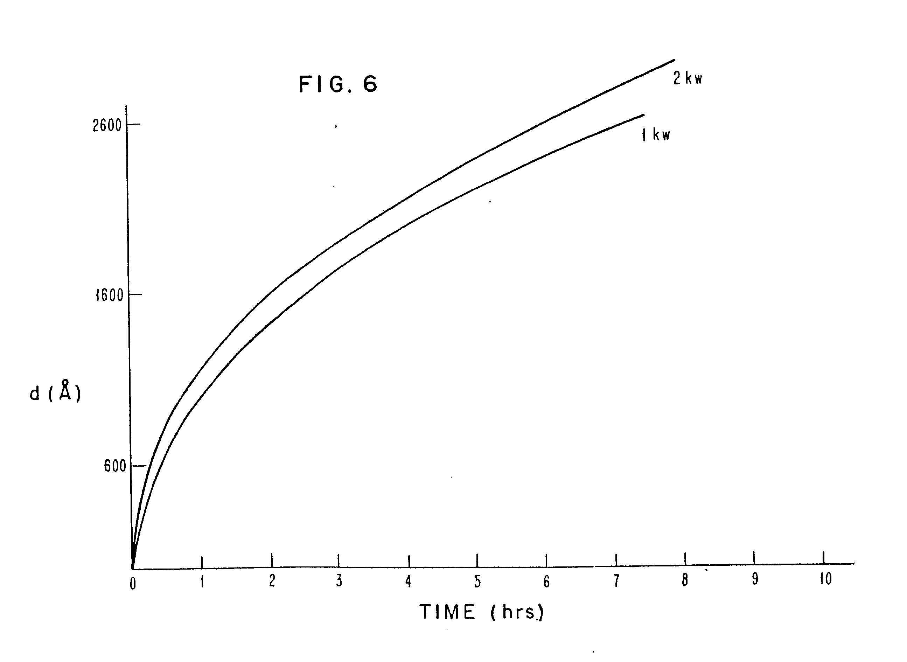

Fig. 6 illustrates oxide thickness as a function of power at conditions of 475°C, oxygen flow rate of 2.15 cm³ per minute, and 4 Pa (30 mTorr). It is noted that the power within the range examined has a small effect on the oxide thickness.

## Claims

1. A process for plasma oxidizing a surface (11) of a substrate (9), said surface being placed essentially perpendicular to the flow of a gas plasma characterized by a pressure in the region surrounding said surface (11) of at least 1.3 Pa (10 mTorr), and said surface (11) to be oxidized facing away from the plasma flow.

2. The process of claim 1, wherein the substrate (11) is a conductor or a semiconductor, in particular impurity doped silicon.

3. The process of claim 1, wherein said pressure is 1.3 to about 13.3 Pa (10 to about 100 mTorr), preferably about 2.6 to about 6.7 Pa (about 20 to about 50 mTorr).

4. The process of claim 1, wherein the temperature of the substrate during the plasma oxidation is about 300°C to about 550°C, preferably about 340°C to about 525°C.

5. The process of claim 1, carried out by controlling independently the temperature of the substrate, the pressure, and the plasma generating power.

6. The process of claim 1, wherein the plasma is generated by applying radio frequency power of about 1 to about 7 kW, preferably 1 to about 2 kW.

7. The process of claim 6, wherein the radio frequency of applied power is about 0.5 to about 8 MHz.

8. The process of claim 1, wherein the oxidizing gas flows at a linear gas stream velocity of about 20 to 30 cm/sec.

9. The process of claim 1, wherein the oxidizing gas flow rate is about 0.7 to 10 cm³/min.

10. The process of claim 1, wherein the substrate (9) is outside of the geometrical confines (8) of the plasma generating means (7).

## Patentansprüche

1. Verfahren zur Plasmaoxidierung einer Oberfläche (11) eines Substrats (9), wobei die Oberfläche im wesentlichen senkrecht zur Flußrichtung eines Gasplasmas angeordnet ist, gekennzeichnet durch einen Druck im Bereich um die Oberfläche (11) von mindestens 1,3 Pa (10 mTorr) und dadurch, daß die zu oxidierende Oberfläche (11) vom Plasmastrom abgewandt ist.

2. Verfahren nach Anspruch 1, in welchem das Substrat (11) ein Leiter oder Halbleiter ist, insbesondere mit Störstellen dotiertes Silicium.

3. Verfahren nach Anspruch 1, in welchem der Druck 1,3 bis ca. 13,3 Pa (10 bis ca. 100 mTorr) beträgt, vorzugsweise ca. 2,6 bis ca. 6,7 Pa (ca. 20 bis ca. 50 mTorr).

4. Verfahren nach Anspruch 1, in welchem die Temperatur des Substrats während der Plasmaoxidierung ca. 300°C bis ca. 550°C beträgt, vorzugsweise ca. 340°C bis ca. 525°C.

5. Verfahren nach Anspruch 1, wobei das Steuern der Temperatur des Substrats, des Druckes und der plasmabildenden Energie unabhängig voneinander erfolgen.

6. Verfahren nach Anspruch 1, bei welchem das Plasma dadurch hergestellt wird, daß Hochfrequenz von ca. 1 bis ca. 7 kW, vorzugsweise 1 bis ca. 2 kW, angewandt wird.

7. Verfahren nach Anspruch 6, bei welchem die Frequenz der angewandten Energie ca. 0,5 bis ca. 8 MHz beträgt.

8. Verfahren nach Anspruch 1, bei welchem sich das oxidierende Gas mit einer linearen Strömungsgeschwindigkeit von ca. 20 bis 30 cm/sec bewegt.

9. Verfahren nach Anspruch 1, bei welchem die Strömungsgeschwindigkeit des oxidierenden Gases ca. 0,7 bis 10 cm³/min beträgt.

10. Verfahren nach Anspruch 1, bei welchem das Substrat (9) sich außerhalb der geometrischen Grenzen (8) der Plasmaerzeugungsmittel (7) befindet.

## Revendications

1. Procédé pour l'oxydation par plasma d'une surface (11) d'un substrat (9), ladite surface étant placée sensiblement perpendiculairement à l'écoulement d'un gaz de plasma, caractérisé par une pression d'au moins 1,3 Pa (10 mTorr) dans la zone entourant ladite surface (11) et par le fait que ladite surface (11) à oxyder est orientée en sens opposé à l'écoulement de plasma.

2. Procédé selon la revendication 1 dans lequel le substrat (11) est un conducteur ou un semiconducteur, en particulier du silicium dopé par impuretés.

3. Procédé selon la revendication 1, caractérisé en ce que ladite pression est comprise entre 1,3 et environ 13,3 Pa (10 à environ 100 mTorr), en étant de préférence d'environ 2,6 à 6,7 Pa (environ 20 à environ 50 mTorr).

4. Procédé selon la revendication 1 dans lequel la température du substrat pendant l'oxydation par plasma est d'environ 300°C à environ 550°C, de préférence d'environ 340°C à environ 525°C.

5. Procédé selon la revendication 1 mis en oeuvre en commandant indépendamment la température du substrat, la pression et l'énergie de génération de plasma.

6. Procédé selon la revendication 1 dans lequel le plasma est engendré par application d'une énergie haute fréquence d'environ 1 à environ 7 kW, de préférence de 1 à environ 2 kW.

7. Procédé selon la revendication 6 dans lequel la haute fréquence de l'énergie appliquée est d'environ 0,5 à environ 8 MHz.

8. Procédé selon la revendication 1 dans lequel le gaz d'oxydation s'écoule à une vitesse linéaire de courant gazeux d'environ 20 à 30 cm/seconde.

9. Procédé selon la revendication 1 dans lequel le débit de gaz d'oxydation est d'environ 0,7 à 10 cm³/minute.

10. Procédé selon la revendication 1 dans lequel le substrat (9) est placé à l'extérieur du contour géométrique (8) du moyen de génération de plasma (7).

FIG. 1

TRAP — OVEN — METER ← O2

TO VACUUM

FIG. 2

O2

TO VACUUM

WATER        WATER

1

FIG. 3

## FIG. 4

FIG.5

3.0 MHz

0.5 MHz

d (Å)

TIME (hrs.)

0 039 406

FIG. 6

d (Å)

2600

1600

600

TIME (hrs.)

0 1 2 3 4 5 6 7 8 9 10

2 kw

1 kw

0 039 406